# EUROPEAN PATENT APPLICATION

(11) **EP 3 637 762 A1**
(43) Date of publication of application: **15.04.2020**
(21) Application number: 18809019.5
(22) Date of filing: 29.05.2018
(51) Int. Cl.: H04N 9/07, G02B 26/00, H04N 5/369

(54) **IMAGING ELEMENT AND IMAGING DEVICE**

(30) Priority: 31.05.2017 JP 2017108826
(71) Applicant: NIKON CORPORATION, Minato-ku Tokyo 108-6290 (JP)
(72) Inventor: NISHIYAMA, Madoka, Tokyo 108-6290 (JP); OHKOUCHI, Naoki, Tokyo 108-6290 (JP); WATANABE, Yoshiyuki, Tokyo 108-6290 (JP); SHIBAZAKI, Kiyoshige, Tokyo 108-6290 (JP); SAKATA, Yasuhiro, Tokyo 108-6290 (JP)
(74) Representative: Hoffmann Eitle
(86) International application number: PCT/JP2018/020559
(87) International publication number: WO 2018/221516

(57) **Abstract**

An imaging device having a multiband is provided. The imaging device includes a first photoelectric conversion element; a second photoelectric conversion element; a fixed mirror and a first moving mirror provided in correspondence to the first photoelectric conversion element and having reflective surfaces respectively facing each other with a first interval; a fixed mirror and a second moving mirror provided in correspondence to the second photoelectric conversion element and having reflective surfaces respectively facing each other with a second interval, the second moving mirror being coupled to the first moving mirror; and a driving member configured to move the first moving mirror and the second moving mirror relative to the fixed mirror.

## Description

### BACKGROUND

### 1. TECHNICAL FIELD

The present invention relates to an imaging device and an imaging apparatus.

### 2. RELATED ART

In the related art, an imaging device having a MEMS-type bandpass filter is known which sweeps a spectrometric wavelength by changing an interval between mirrors facing each other and acquires a multiband image (For example, refer to Patent Document 1).
Patent Document 1: Japanese Patent Application Publication No. 2010-102150

However, according to an imaging apparatus of the related art, when dispersing light into a plurality of bands, it is necessary to change the interval between the mirrors by the number of the bands to be dispersed.

An imaging device according to a first aspect of the present invention includes a first photoelectric conversion element; a second photoelectric conversion element adjacent to the first photoelectric conversion element; a fixed mirror and a first moving mirror provided in correspondence to the first photoelectric conversion element and having reflective surfaces respectively facing each other with a first interval; a fixed mirror and a second moving mirror provided in correspondence to the second photoelectric conversion element and having reflective surfaces respectively facing each other with a second interval, the second moving mirror being coupled to the first moving mirror; and a driving member configured to move the first moving mirror and the second moving mirror relative to the fixed mirror. Also, the driving member may be configured to move the first moving mirror and the second moving mirror so that the first interval after movement of the first moving mirror and the second moving mirror is to be an interval different from the second interval before the movement.

An imaging apparatus according to a second aspect of the present invention includes the imaging device according to the first aspect; a receiving unit configured to receive switching information indicating whether or not to move the first moving mirror and the second moving mirror; and an instruction unit configured to instruct the driving member to drive the first moving mirror and the second moving mirror, based on the switching information.

In the meantime, the summary of the present invention does not necessarily describe all necessary features of the present invention. The present invention may also be a sub-combination of the features described above.

### BRIEF DESCRIPTION OF THE DRAWINGS

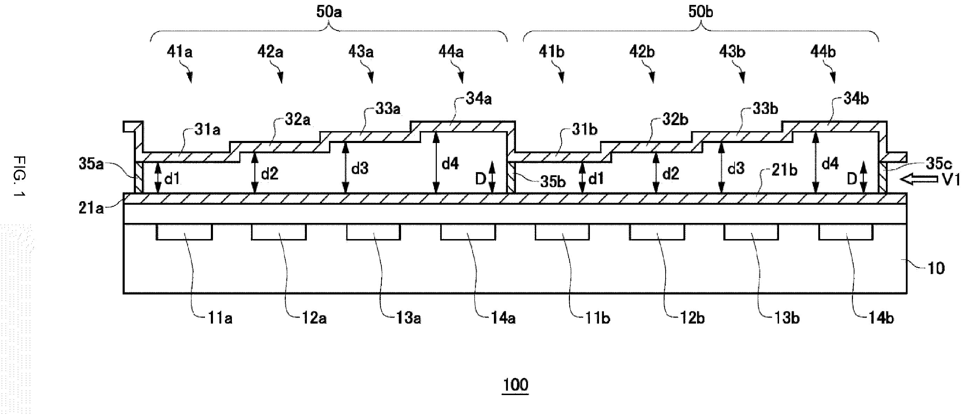

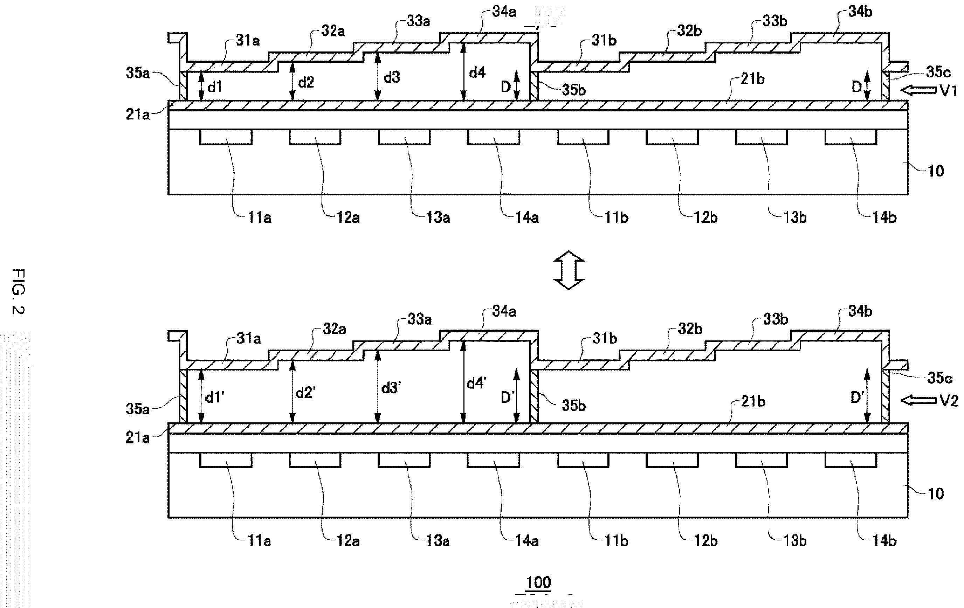

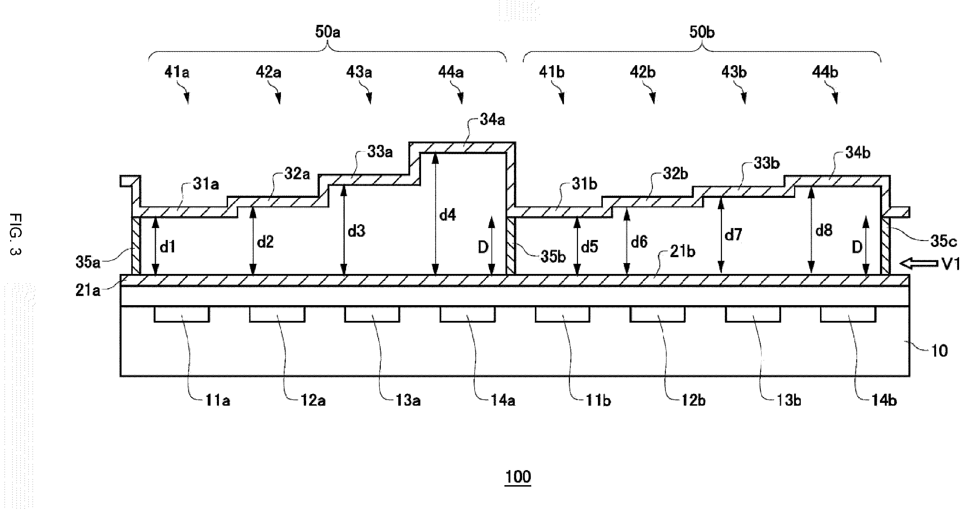

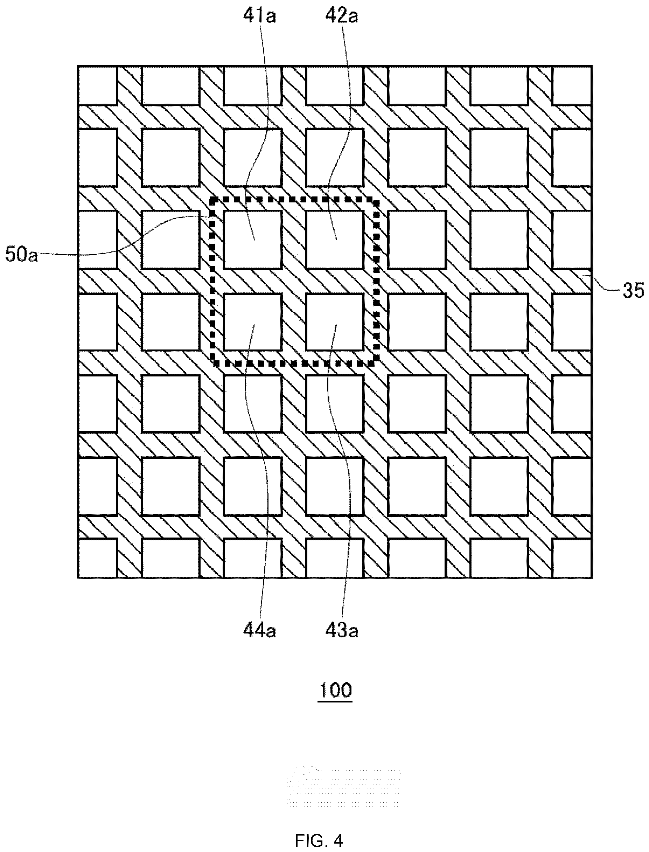

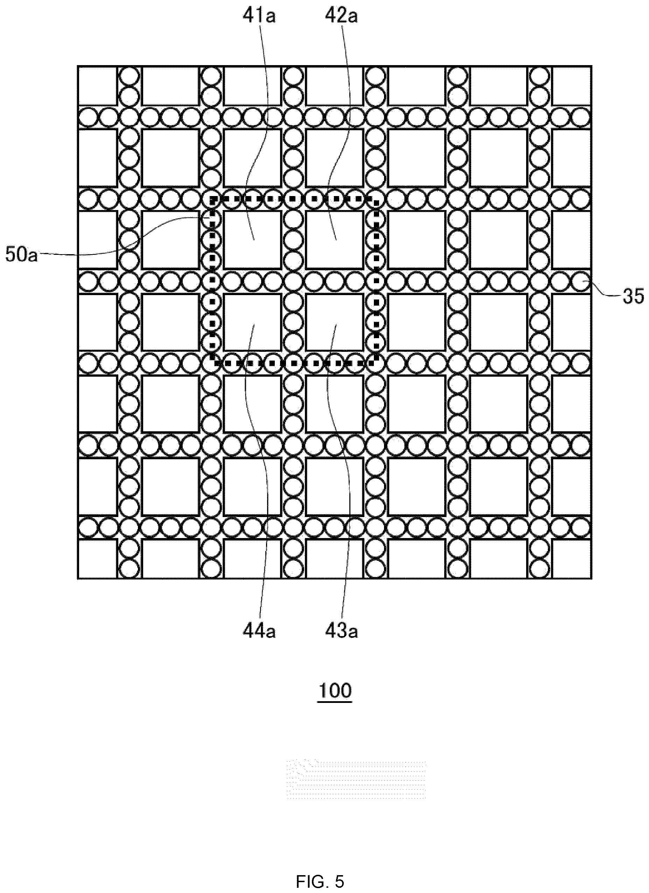

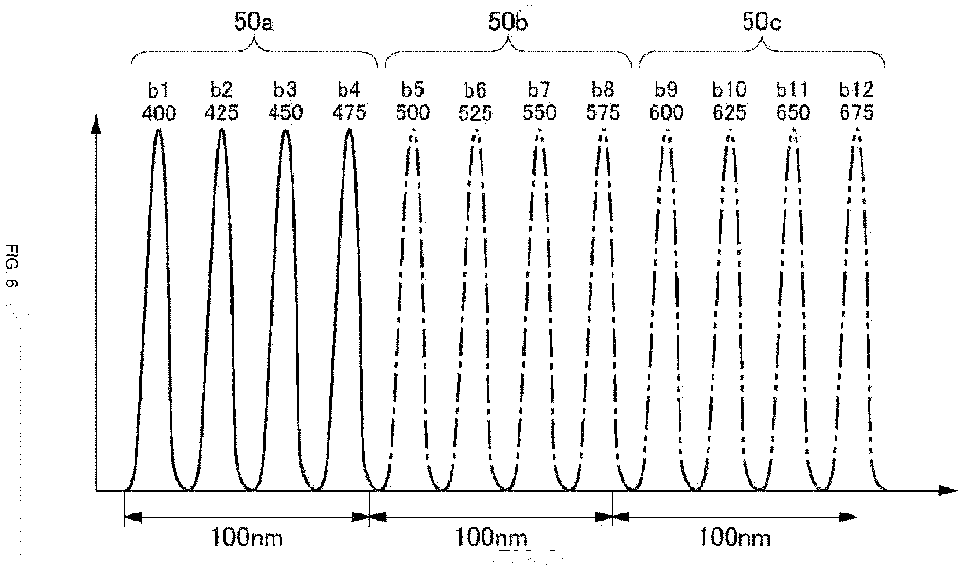

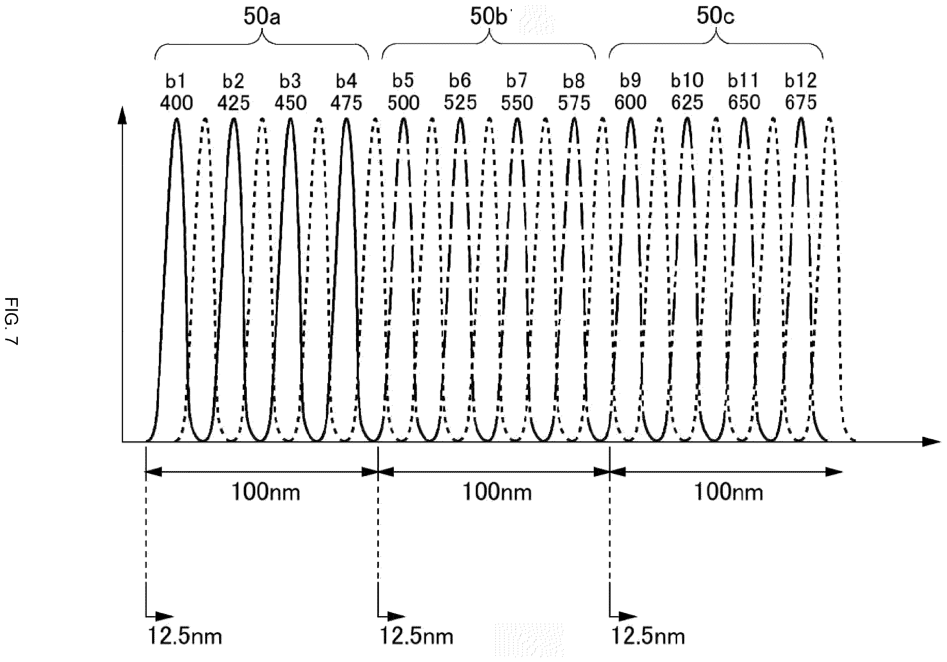

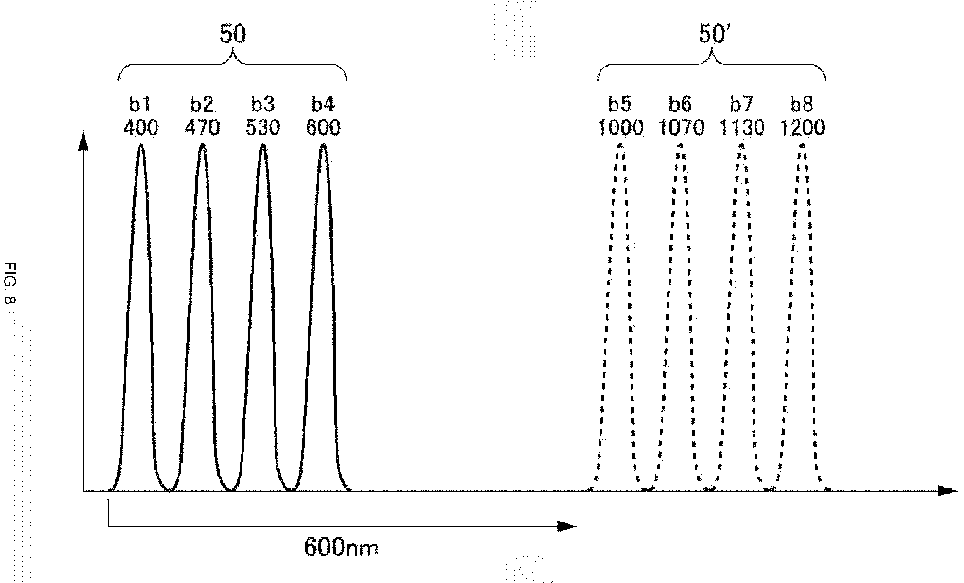

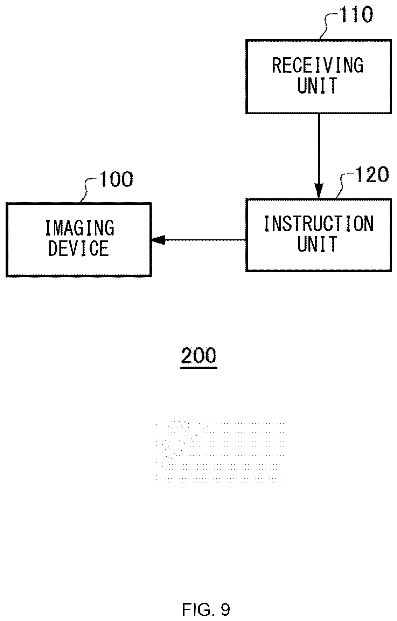

FIG. 1 shows an example of a configuration of an imaging device 100 according to a first embodiment. FIG. 2 shows an example of the configuration before and after driving of the imaging device 100 according to the first embodiment. FIG. 3 shows an example of a configuration of the imaging device 100 according to a second embodiment. FIG. 4 shows an example of a plan view of the imaging device 100 according to a third embodiment. FIG. 5 shows an example of a plan view of the imaging device 100 according to a fourth embodiment. FIG. 6 shows an example of a multiband configured by the imaging device 100. FIG. 7 shows an example of the multiband configured by the imaging device 100. FIG. 8 shows an example of the multiband configured by the imaging device 100. FIG. 9 shows an outline of a configuration of an imaging apparatus 200.

### DESCRIPTION OF EXEMPLARY EMBODIMENTS

Herein below, embodiments of the present invention will be described. The embodiments do not limit the invention defined in the claims. Also, all combinations of features described in the embodiment are not necessarily essential to solving means of the invention.

### [First Embodiment]

FIG. 1 shows an example of a configuration of an imaging device 100 according to a first embodiment. In the first embodiment, the imaging device 100 includes a plurality of multiband units 50 formed on a substrate 10. In FIG. 1, two multiband unit 50a and multiband unit 50b of the imaging device 100 are described as an example. In the first embodiment, a case in which one unit band is four bands is described. One unit band indicates the number of bands included in the multiband unit 50. Also, in the first embodiment, a case in which filters of the multiband unit 50 are aligned side by side is described. However, as described later, the filters of the multiband unit 50 may be aligned in a lattice form.

The substrate 10 includes a plurality of photoelectric conversion elements. The photoelectric conversion element is configured to receive light having transmitted through the filter of the multiband unit 50. In FIG. 1, the eight photoelectric conversion elements of a photoelectric conversion element 11a to a photoelectric conversion element 14a and a photoelectric conversion element 11b to a photoelectric conversion element 14b are shown. Herein, the photoelectric conversion element 11a to the photoelectric conversion element 14a are respectively positioned adjacent to each other. The photoelectric conversion element 11b to the photoelectric conversion element 14b are also respectively positioned adjacent to each other. In the meantime, regarding the configuration in which the photoelectric conversion elements are adjacent to each other, a reading circuit and the like may be positioned therebetween, and the photoelectric conversion elements are not necessarily required to contact each other. In the multiband unit 50, it is preferable that lights in bands different for each of the photoelectric conversion elements are incident. Thereby, for each of the multiband units 50, information about the multiband is obtained.

The multiband unit 50 includes a plurality of filters. For example, the multiband unit 50a includes four filters of a filter 41a, a filter 42a, a filter 43a, and a filter 44a. Also, the multiband unit 50b includes four filters of a filter 41b, a filter 42b, a filter 43b, and a filter 44b. In the specification, the four filters of each of the multiband units 50 are collectively referred to as the filter 41 to the filter 44. In the meantime, the number of the filters of the multiband unit 50 may be changed, in correspondence to the number of the photoelectric conversion elements of the multiband unit 50.

The filter 41 to the filter 44 have a moving mirror 31 to a moving mirror 34 facing a fixed mirror 21, respectively. The fixed mirror 21 may be commonly used for the filter 41 to the filter 44, and may have a planar shape. The moving mirror 31 to the moving mirror 34 may be members coupled to each other, and may have a step shape in which a step is generated for each mirror. The filter 41 to the filter 44 are configured to cause lights in wavelength bands to transmit therethrough, which correspond to intervals between the fixed mirror 21 and the moving mirror 31 to moving mirror 34 facing the fixed mirror 21. In the first embodiment, since the intervals of the moving mirror 31 to the moving mirror 34 from the fixed mirror 21 are different, the filter 41 to the filter 44 configure the multiband corresponding to the number of the filters, even without driving a driving member 35. The multiband unit 50a includes the filter 41a to the filter 44a, and the multiband unit 50b includes the filter 41b to the filter 44b.

The filter 41a includes a fixed mirror 21a and a moving mirror 31a, which are all translucent. The fixed mirror 21a and the moving mirror 31a are provided, in correspondence to the photoelectric conversion element 11a, and have reflective surfaces respectively facing each other. The filter 41a is configured to cause light in a wavelength band, which corresponds to an interval d1 between the fixed mirror 21a and the moving mirror 31a, to transmit therethrough. The photoelectric conversion element 11a is configured to receive the light having transmitted through the filter 41a.

The filter 42a includes the fixed mirror 21a and a moving mirror 32a. The fixed mirror 21a and the moving mirror 32a are provided, in correspondence to the photoelectric conversion element 12a, and have reflective surfaces respectively facing each other. Also, the filter 42a is coupled to the filter 41a. The filter 42a is configured to cause light in a wavelength band, which corresponds to an interval d2 between the fixed mirror 21a and the moving mirror 32a, to transmit therethrough. The photoelectric conversion element 12a is configured to receive the light having transmitted through the filter 42a.

The filter 43a includes the fixed mirror 21a and a moving mirror 33a. The fixed mirror 21a and the moving mirror 33a are provided, in correspondence to the photoelectric conversion element 13a, and have reflective surfaces respectively facing each other. Also, the filter 43a is coupled to the filter 42a. The filter 43a is configured to cause light in a wavelength band, which corresponds to an interval d3 between the fixed mirror 21a and the moving mirror 33a, to transmit therethrough. The photoelectric conversion element 13a is configured to receive the light having transmitted through the filter 43a.

The filter 44a includes the fixed mirror 21a and a moving mirror 34a. The fixed mirror 21a and the moving mirror 34a are provided, in correspondence to the photoelectric conversion element 14a, and have reflective surfaces respectively facing each other. Also, the filter 44a is coupled to the filter 43a. The filter 44a is configured to cause light in a wavelength band, which corresponds to an interval d4 between the fixed mirror 21a and the moving mirror 34a, to transmit therethrough. The photoelectric conversion element 14a is configured to receive the light having transmitted through the filter 44a. In the meantime, the interval d1 to the interval d4 are intervals different from each other.

The driving member 35 is coupled to the moving mirror 31 to the moving mirror 34, and is configured to move the coupled moving mirror 31 to moving mirror 34. As an example, when the driving member 35 is coupled to the moving mirror 31a and the moving mirror 34a, the driving member is not required to be directly coupled to the moving mirror 32a and the moving mirror 33a. That is, the driving member 35 may be indirectly coupled to the moving mirror 32a and the moving mirror 33a via the moving mirror 31a and the moving mirror 34a.

In the first embodiment, the driving member 35 is a MEMS element provided between the fixed mirror 21 and at least one of the moving mirror 31 to the moving mirror 34. For example, the MEMS element includes at least one of a piezoelectric element (i.e., a piezo element) exhibiting a piezoelectric effect and a voltage-driving element using electrostatic force. The driving member 35 is configured to change the intervals between the fixed mirror 21 and the moving mirror 31 to the moving mirror 34 by moving vertically the moving mirror 31 to the moving mirror 34.

For example, the multiband unit 50a includes a driving member 35a and a driving member 35b. The driving member 35a is coupled to the moving mirror 31a, and the driving member 35b is coupled to the moving mirror 34a. Also, the driving member 35a is configured to support the moving mirror 31a, and the driving member 35b is configured to support the moving mirror 34a. Thereby, the driving member 35a and the driving member 35b can change heights of the moving mirror 31a to the moving mirror 34a. The driving member 35a is an example of the MEMS element configured to support the moving mirror 31a, and the driving member 35b is an example of the MEMS element configured to support the moving mirror 34a.

In the first embodiment, the driving member 35 is configured to operate in a voltage driving manner, so that when a driving voltage is applied, a height D of the driving member 35 is changed.. Also, in the first embodiment, the driving member 35 is applied with a preset driving voltage V1. As an example, the driving voltage V1 is 0 (zero), and the driving member 35 is not applied with a voltage. In the first embodiment, the driving members 35 have the same height D in a state in which the same driving voltage V1 is applied.

The filter 41 to the filter 44 are provided so that differences between the intervals of the moving mirrors of the adjacent filters are equal. That is, a difference between the interval d1 and the interval d2, a difference between the interval d2 and the interval d3, and a difference between the interval d3 and the interval d4 are the same. Thereby, peaks of the multiband are equally distributed. In the meantime, the intervals between the moving mirrors of the filter 41 to the filter 44 may not be equal.

In the first embodiment, the multiband unit 50b has the same structure as the multiband unit 50a. That is, the multiband unit 50b has a configuration in which intervals between a fixed mirror 21b and a moving mirror 31b to a moving mirror 34b of a filter 41b to a filter 44b are the same as the intervals d1 to d4 in the multiband unit 50a. Also, a driving member 35c coupled to the moving mirror 34b may have the same height D as the driving member 35a and the driving member 35b, in the state in which the same driving voltage V1 is applied. On the other hand, the structure of the multiband unit 50b may be different from the structure of the multiband unit 50a.

In the below, an example of a manufacturing method of the imaging device 100 is described. After forming a film of the fixed mirror 21, a resist is coated on the fixed mirror 21 by a semiconductor process. Next, the resist is exposed and developed in accordance with a pattern of the driving member 35, so that the driving member 35 is prepared. For example, after preparing a material of the driving member 35 on a film, the film is peeled off, so that only a part becoming the driving member 35 is transferred. Both ends of the driving member 35 are provided with electrodes that are to connect to the fixed mirror and the moving mirror.

Thereafter, a step-shaped resist is formed so as to form the moving mirrors. The step-shaped resist is a sacrificial layer that is to be removed by etching after forming the moving mirrors. For example, a resist is applied in an area corresponding to the filters 41a to 44a, and an area of the filter 41a is exposed, so that the resist having a step in the area of the filter 41a is patterned.. The resist is further applied on the patterned resist, and areas of the filter 41a and the filter 42a are exposed, so that a resist having steps in the areas of the filter 41a and the filter 42a is formed. Accordingly, the step-shaped resist is formed by repeating the applying and exposure of the resist. Then, a film of the moving mirrors is formed on the step-shaped resist, so that step-shaped moving mirrors are formed.

In the meantime, the fixed mirror 21 and the moving mirror 31 are respectively formed of a multi-layered film in which a high refractive index layer such as SiN and a low refractive index layer such as SiO₂ are stacked, as an example. Also, the fixed mirror 21 and the moving mirror may be formed of a metal film such as gold, silver, aluminum or the like, respectively. For example, the fixed mirror 21 and the moving mirror may be formed by a sputter method, an ion beam sputter method or the like.

After forming the fixed mirror 21 and the moving mirror 31, the resist that has been used so as to form the moving mirror and the driving member 35 may be completely removed by a sacrificial layer etching process. Thereby, spaces of the interval d1 to the interval d4 are formed. Also, the sacrificial layer may be etched by forming a fine hole (i.e., an etching hole) in the vicinity of a center of the mirror. A diameter of the etching hole is preferably equal to or smaller than λ/10, which does not affect optically.

FIG. 2 shows an example of the configuration before and after driving of the imaging device 100 according to the first embodiment. FIG. 2 shows a change in state when a driving voltage V1 is applied to the driving member 35 of the imaging device 100 and when a driving voltage V2 is applied to the same.

The height of the driving member 35 changes, in correspondence to the applied driving voltage. As an example, the driving member 35 positions the moving mirror 31 to the moving mirror 34 to a position of a second step. For example, when the driving voltage V1 is applied, the driving member 35 is located at the height D, and when the driving voltage V2 is applied, the driving member is located at a height D' different from the height D. Thereby, the driving member 35 controls positions of the moving mirror 31 to the moving mirror 34.

As an example, the driving voltage V1 is higher than the driving voltage V2. When the driving voltage V2 higher than the driving voltage V1 is applied, the driving member 35 is located at a height higher than the state in which the driving voltage V1 is applied. That is, the height D' of the driving member 35 in the state in which the driving voltage V2 is applied is greater than the height D of the driving member 35 in the state in which the driving voltage V1 is applied. In the meantime, in a case in which the driving voltage V1 is 0 (zero), the imaging device 100 drives the multiband unit 50 by on and off of the driving voltage to be applied to the driving member 35.

For the moving mirror 31 to the moving mirror 34, positions of two steps are preferably set so that the intervals d1 to d4 before movement and the intervals d1' to d4' after movement are all different, respectively. For example, the moving mirror 31 to the moving mirror 34 are preferably moved so that the interval d1' after driving of the imaging device 100 is to be an interval different from the intervals d1 to d4 before driving of the imaging device 100. Thereby, lights in wavelength bands corresponding to the eight intervals of the intervals d1 to d4 and the intervals d1' to d4' are to be transmitted. Therefore, the imaging device 100 can detect lights in eight bands. In the meantime, the moving mirror 31 to the moving mirror 34 may be moved so that the interval d1' after driving of the imaging device 100 is to be an interval different from at least the interval d2 before driving of the imaging device 100. Thereby, lights in wavelength bands corresponding to the four intervals of the intervals d1 and d2 and the intervals d1' and d2' are caused to transmit by at least the filter 41 and the filter 42.

The imaging device 100 of the first embodiment is configured to apply the two driving voltages of the driving voltage V1 and the driving voltage V2 to the driving member but may be configured to apply three or more different driving voltages to the driving member 35. Thereby, it is possible to obtain an image including more bands. However, from a standpoint of simultaneity, the multiband unit 50 is preferably driven by the two driving voltages. Also, upon the driving of the MEMS element, when it is intended to drive the same with any of continuous driving voltages, the driving voltage may not be equal. In this case, the position of the moving mirror is not stable, which varies the wavelength band in which the light is caused to transmit. However, when the MEMS element is driven by the two driving voltages of on and off, the driving voltage becomes stable, so that it is possible to increase accuracy of the wavelength band in which the light is caused to transmit. The multiband unit 50 of the first embodiment can detect the lights in the plurality of wavelength bands, which correspond to the filters in which the intervals between the mirrors are different even in the state in which the driving voltage is not applied. Therefore, even when the driving voltage is set to two steps of on and off, the lights in wavelength bands twice the number of the filters can be detected with accuracy.

The imaging device 100 is configured to acquire a multiband image corresponding to positions of the multiband unit 50 before and after the driving by driving the multiband unit 50 with the driving member 35. Thereby, the imaging device 100 can acquire the multiband image in a shorter time, as compared to a case in which a single band unit is driven. Therefore, it is possible to implement the high-speed capturing of the multiband image. Also, in the multiband unit 50, it is possible to acquire the multiband image without deteriorating the simultaneity.

### [Second Embodiment]

FIG. 3 shows an example of a configuration of the imaging device 100 according to a second embodiment. In the second embodiment, the imaging device 100 includes the multiband unit 50a and the multiband unit 50b in which the intervals between the fixed mirror 21 and the moving mirror 31 to the moving mirror 34 are different. In the second embodiment, the features different from the imaging device 100 according to the first embodiment are particularly described.

The intervals d1 to d4 in the multiband unit 50a are different from intervals d5 to d8 in the multiband unit 50b. In the meantime, the multiband unit 50a and the multiband unit 50b are provided with the driving member 35a to the driving member 35c of which the heights D are the same. Thereby, the imaging device 100 of the second embodiment can detect lights in more bands, even when the driving voltages to be applied to the driving members 35 are the same. Also, the interval differences between the intervals d1 to d4 in the multiband unit 50a and the interval differences between the intervals d5 to d8 in the multiband unit 50b can be freely set for each of the bands. Therefore, the imaging device 100 of the second embodiment can easily acquire information about necessary bands in a selective manner.

As an example, a density of bands in the multiband unit 50a is set high, and a density of bands in the multiband unit 50b is set low. Also, the intervals d1 to d4 in the multiband unit 50a may be made to correspond to a visible light region, and the intervals d5 to d8 in the multiband unit 50b may be made to correspond to an infrared light region. Thereby, it is possible to easily acquire data of optimal multiband in the visible light region and the infrared light region, respectively.

The moving mirror 31 to the moving mirror 34 are configured so that the intervals of the bands of the multiband unit 50 are unequal, unlike the imaging device 100 according to the first embodiment. For example, before the moving mirror 31a to the moving mirror 34a move, the difference between the interval d1 and the interval d2, the difference between the interval d2 and the interval d3 and the difference between the interval d3 and the interval d4 are unequal. Accordingly, the moving mirror 31a to the moving mirror 34a are not necessarily required to be arranged so that the intervals of the bands of the multiband unit 50 are equal. For example, the imaging device 100 may be configured to increase the density of bands in a relatively important wavelength band and to decrease the density of bands in a relatively unimportant wavelength band. Thereby, the imaging device 100 can effectively detect the light in the necessary wavelength band.

### [Third Embodiment]

FIG. 4 shows an example of a plan view of the imaging device 100 according to a third embodiment. An area surrounded by the broken line corresponds to an area in which the multiband unit 50a is formed. In the multiband unit 50a, the filter 41a to the filter 44a are provided in a lattice pattern. However, the filter 41a to the filter 44a may be arranged in a serial or other pattern.

The driving member 35 is provided between the filter 41a to the filter 44a provided in a lattice pattern. The driving member 35 of the third embodiment is commonly provided between the adjacent filters but may be provided for each of the filters. The driving member 35 is commonly provided to all the filters, so that it is possible to drive all the filters substantially at the same time.

The plurality of photoelectric conversion elements is aligned in a planar pattern. The plurality of filters 41a to the filter 44a corresponds to the plurality of photoelectric conversion elements, and forms the multiband unit 50a having a planar shape. In the third embodiment, the filter 41a to the filter 44a are aligned in a planar pattern, in correspondence to the plurality of photoelectric conversion elements (not shown). The plurality of filters 41a to the filter 44a may be provided in an irregular pattern in the multiband unit 50a. That is, regarding the plurality of filters, the filters having close bands, as described in the first and second embodiments, are not required to be arranged adjacent to each other, and the plurality of filters may be irregularly arranged, irrespective of the magnitudes of the bands.

In the third embodiment, the multiband unit 50a is configured in a 2×2 pitch. However, the multiband unit 50a may be configured in a 3×3 pitch or in a 4×4 pitch. Also, in the multiband unit 50a of the third embodiment, the filters are arranged in a square pattern. However, the filters may be arranged in a different pattern such as a rectangular pattern or a T-shaped pattern.

The imaging device 100 includes the plurality of filters having different bands, so that it is possible to acquire a variety of information about the different wavelength bands. For example, the imaging device 100 may use the acquired information for estimation of a spectrum or determination about properties of liquid from a two-dimensional image.

### [Fourth Embodiment]

FIG. 5 shows an example of a plan view of the imaging device 100 according to a fourth embodiment. The imaging device 100 of the fourth embodiment is different from the imaging device 100 of the third embodiment, in that it includes a pillar-shaped driving member 35. In the fourth embodiment, differences from the third embodiment are particularly described.

The driving member 35 has pillar-shaped MEMS elements between the fixed mirror 21 and at least one of the moving mirror 31 to the moving mirror 34. The driving member 35 has the pillar-shaped MEMS elements, so that it is possible to control the heights D of the moving mirror 31a to the moving mirror 34a for each of the filter 41a to the filter 44a. The plurality of driving members 35 may be shared by the adjacent filters.

The plurality of driving members 35 may have different heights, in correspondence to the adjacent filters, in the state in which the same driving voltage is applied. As an example, the heights D of the driving members 35 may be made different on a central side of the multiband unit 50 and on an outer periphery side of the multiband unit 50. For example, the height of the driving member 35 on the central side of the multiband unit 50 is made low, and the height of the driving member 35 on the outer periphery side of the multiband unit 50 is made high. Also, the height of the driving member 35 on the central side of the multiband unit 50 may be made high, and the height of the driving member 35 on the outer periphery side of the multiband unit 50 may be made low.

The spectral filters have an angle dependency, respectively, so that when the light is obliquely incident on the moving mirror, the wavelength band of the light to transmit may be different from a desired wavelength band. Also, in a case of different main lenses (for example, in a case of replacing lenses), an incident angle on a sensor may be different on an optical axis and on the other sides except the optical axis. In contrast, according to the imaging device 100 of the fourth embodiment, the height of the driving member 35 on the outer periphery side of the multiband unit 50 is made high, for example, so that it is possible to reduce the incident light dependency by varying the angle of the filter in a position (i.e., on the outer periphery side of the multiband unit 50) of the sensor except the optical axis. In the meantime, the imaging device 100 may be configured to adjust the heights of the multiband units 50 to different heights, in correspondence to the angle of the incident light. Thereby, the imaging device 100 can adjust the incident angle on each filter so as to approximate to the vertical incidence.

As a modified embodiment of the fourth embodiment, the filter 41a to the filter 44a may be independently provided in the imaging device 100. In this case, the pillar-shaped driving members 35 are arranged side by side by two in each row or in each column so as to independently support the adjacent spectral filters. The imaging device 100 can independently change each height D of the filter 41a to the filter 44 and the moving mirror 31a to the moving mirror 34a by applying an independent driving voltage to each of the driving members 35.

FIG. 6 shows an example of the multiband configured by the imaging device 100. In the present example, the bands that are formed by the multiband unit 50a to the multiband unit 50c of the imaging device 100 are described. In the present example, the multiband unit 50a to the multiband unit 50c have a pitch of 100 nm per one band.

The multiband unit 50a forms a multiband having four peaks b1 to b4. The multiband of the multiband unit 50a includes four peaks of 400 nm, 425 nm, 450 nm and 475 nm. The multiband unit 50b forms a multiband having four peaks b5 to b8. The multiband of the multiband unit 50b includes four peaks of 500 nm, 525 nm, 550 nm and 575 nm. The multiband unit 50c forms a multiband having four peaks b9 to b12. The multiband of the multiband unit 50c includes four peaks of 600 nm, 625 nm, 650 nm and 675 nm.

In the present example, the imaging device 100 includes the three multiband units of the multiband unit 50a to the multiband unit 50c each of which includes the four bands. That is, the imaging device 100 has the twelve bands before the driving of the multiband unit 50. That is, the imaging device 100 of the present example can acquire the multiband images having the twelve bands at the same time. Accordingly, the plurality of the multiband units 50 each of which includes the plurality of bands is provided, so that the simultaneity of the multiband images is improved.

FIG. 7 shows an example of the multiband configured by the imaging device 100. In the present example, the bands that are formed by the multiband unit 50a to the multiband unit 50c of the imaging device 100 are described. In the present example, the multiband unit 50a to the multiband unit 50c have a pitch of 100 nm per one band.

The solid line indicates band characteristics of the multiband unit 50a. The dashed-dotted line indicates band characteristics of the multiband unit 50b. The dashed-two dotted line indicates band characteristics of the multiband unit 50c. That is, each band of the multiband unit 50a to the multiband unit 50c is the same as the multiband shown in FIG. 6.

In the present example, the imaging device 100 drives the multiband unit 50a to the multiband unit 50c, thereby offsetting the bands toward a wavelength higher by a half band (i.e., 12.5 nm). Thereby, the band characteristics of the multiband unit 50a to the multiband unit 50c are changed to band characteristics shown with the broken line. The imaging device 100 drives the plurality of multiband unit 50a to the multiband unit 50c, thereby obtaining twelve bands that are further different. Thereby, the imaging device 100 can acquire the multiband images including the twenty four bands at high speed. In this way, the imaging device 100 includes the multiband unit 50 configuring the multiband and the driving member 35 for driving the multiband unit 50, thereby implementing the multiband variable sensor.

Accordingly, the imaging device 100 can acquire the multiband images having twice bands by moving the moving mirrors, in correspondence to the half pitch between the adjacent bands. In particular, the imaging device 100 may drive the multiband unit 50 by a distance corresponding to a 1/3 pitch or a 2/3 pitch without being limited to the half pitch, as long as the band after movement does not overlap the other bands.

FIG. 8 shows an example of the multiband configured by the imaging device 100. In the present example, the bands that are formed by the multiband unit 50 of the imaging device 100 are described.

The multiband unit 50 forms a multiband having four peaks b1 to b4. The multiband of the multiband unit 50 includes four peaks of 400 nm, 470 nm, 530 nm and 600 nm. That is, the multiband unit 50 has the multiband in the visible light region before the driving. The imaging device 100 drives the multiband unit 50, thereby offsetting the bands toward a wavelength higher by 600 nm. Thereby, the imaging device 100 converts the band b1 (400 nm), the band b2 (470 nm), the band b3 (530 nm) and the band b4 (600 nm) in the visible light region into the band b5 (1000 nm), the band b6 (1070 nm), the band b7 (1130 nm) and the band b8 (1200 nm) in the infrared light region.

In the present example, the imaging device 100 drives the multiband unit 50, thereby acquiring the information about the multiband in both the visible light region and the infrared light region. Since the imaging device 100 acquires the information about the multiband in both the visible light region and the infrared light region by driving the multiband unit 50 just once, it is possible to acquire the multiband images in the visible light region and the infrared light region at high speed.

FIG. 9 shows an outline of a configuration of an imaging apparatus 200. In the present example, the imaging apparatus 200 includes the imaging device 100, a receiving unit 110, and an instruction unit 120. The imaging device 100 is configured to receive the light incident on imaging device 100 at preset timing.

The receiving unit 110 is configured to receive switching information indicating whether or not to move the moving mirrors. For example, in a case in which the imaging apparatus 200 is a camera, the receiving unit 110 is an operation button of the camera. The receiving unit 110 is configured to switch whether or not to drive the multiband unit 50, in correspondence to the switching information. For example, the switching information includes an input from a user of the imaging device 100. Also, the switching information may include automatic conversion by image recognition of a photographic subject. Also, the receiving unit 110 may be configured to automatically drive the multiband unit 50 after a preset time period since a capturing of the imaging apparatus 200 starts. In this case, the multiband images before and after the driving of the multiband unit 50 are automatically acquired.

The instruction unit 120 is configured to input a signal, which corresponds to the switching information received by the receiving unit 110, to the imaging device 100. For example, the instruction unit 120 applies the driving voltage to the driving member 35 at timing corresponding to the switching information from the receiving unit 110, thereby instructing the driving of the multiband unit 50. Thereby, the imaging device 100 acquires the multiband image in bands different from those before the driving.

While the embodiments of the present invention have been described, the technical scope of the invention is not limited to the above described embodiments. It is apparent to persons skilled in the art that various alterations and improvements can be added to the above-described embodiments. It is also apparent from the scope of the claims that the embodiments added with such alterations or improvements can be included in the technical scope of the invention.

The operations, procedures, steps, and stages of each process performed by an apparatus, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order.

### EXPLANATION OF REFERENCES

10···substrate, 11···photoelectric conversion element, 12···photoelectric conversion element, 13···photoelectric conversion element, 14···photoelectric conversion element, 21···fixed mirror, 31···moving mirror, 32···moving mirror, 33···moving mirror, 34···moving mirror, 35···driving member, 41···filter, 42···filter, 43···filter, 44···filter, 50···multiband unit, 100···imaging device, 110···receiving unit, 120···instruction unit, 200···imaging apparatus

## Claims

1. An imaging device comprising:
a first photoelectric conversion element;
a second photoelectric conversion element adjacent to the first photoelectric conversion element;
a fixed mirror and a first moving mirror provided in correspondence to the first photoelectric conversion element and having reflective surfaces, respectively, facing each other with a first interval;
the fixed mirror and a second moving mirror provided in correspondence to the second photoelectric conversion element and having reflective surfaces, respectively, facing each other with a second interval, the second moving mirror being coupled to the first moving mirror; and
a driving member that moves the first moving mirror and the second moving mirror relative to the fixed mirror, wherein
the driving member moves the first moving mirror and the second moving mirror so that the first interval after movement of the first moving mirror and the second moving mirror is to be an interval different from the second interval before the movement.

2. The imaging device according to Claim 1, wherein
the driving member is configured to locate the first moving mirror and the second moving mirror to positions of a second step, depending on whether a driving voltage is applied or not, and
the positions of the first moving mirror and the second moving mirror in the second step are set so that all intervals of the first interval and the second interval in the positions of the second step are different.

3. The imaging device according to Claim 1 or 2, wherein
the driving member is a pillar-shaped MEMS element provided between the fixed mirror and at least one of the first moving mirror and the second moving mirror.

4. An imaging device according to one of Claims 1 to 3, wherein
a driving member comprises a first MEMS element configured to support the first moving mirror and a second MEMS element configured to support the second moving mirror, and
a height of the first MEMS element is same as a height of the second MEMS element in a state in which a same driving voltage is applied.

5. An imaging device according to one of Claims 1 to 3, wherein
a driving member comprises a first MEMS element configured to support the first moving mirror and a second MEMS element configured to support the second moving mirror, and
a height of the first MEMS element is different from a height of the second MEMS element in a state in which a same driving voltage is applied.

6. An imaging device according to one of Claims 1 to 5, further comprising:
a third photoelectric conversion element adjacent to a first photoelectric conversion element or a second photoelectric conversion element, and
a fixed mirror and a third moving mirror provided in correspondence to the third photoelectric conversion element and having reflective surfaces facing each other with a third interval, the third moving mirror being coupled to the first moving mirror or the second moving mirror, wherein
a difference between a first interval and the second interval and a difference between the second interval and the third interval are equal before the first moving mirror, the second moving mirror and third moving mirror are moved.

7. An imaging device according to one of Claims 1 to 5, further comprising:
a third photoelectric conversion element adjacent to a first photoelectric conversion element or a second photoelectric conversion element, and
a fixed mirror and a third moving mirror provided in correspondence to the third photoelectric conversion element and having reflective surfaces facing each other with a third interval, the third moving mirror being coupled to the first moving mirror or the second moving mirror, wherein
a difference between a first interval and the second interval and a difference between the second interval and the third interval are unequal before the first moving mirror, the second moving mirror and third moving mirror are moved.

8. An imaging device according to one of Claims 1 to 7, further comprising:
a plurality of photoelectric conversion elements comprising a first photoelectric conversion element and a second photoelectric conversion element, and
a fixed mirror and a plurality of moving mirrors comprising the first moving mirror and the second moving mirror provided in correspondence to the plurality of photoelectric conversion elements and having reflective surfaces facing each other with different intervals for each of the photoelectric conversion elements, wherein
the plurality of photoelectric conversion elements is aligned in a planar pattern,
a plurality of filters comprising the fixed mirror and the plurality of moving mirrors forms a multiband unit having a planar shape, in correspondence to the plurality of photoelectric conversion elements, and
the plurality of filters is irregularly aligned in the multiband unit.

9. An imaging apparatus comprising:
the imaging device according to any one of Claims 1 to 8;
a receiving unit configured to receive switching information indicating whether or not to move the first moving mirror and the second moving mirror; and
an instruction unit configured to instruct a driving member to drive the first moving mirror and the second moving mirror, based on the switching information.
